# EUROPEAN PATENT SPECIFICATION

(11) **EP 0 559 379 B1**
(45) Date of publication and mention of the grant of the patent: **24.09.1997**
(21) Application number: 93301422.7
(22) Date of filing: 25.02.1993
(51) Int. Cl.: C23F 1/44

(54) **Method for stripping tin or tin-lead alloy from copper surfaces**
Verfahren zur Entfernung Zinn oder Zinn-Bleilegierungen von Kupferoberflächen
Procédé pour enlever de l'étain ou un alliage étain-plomb de surfaces de cuivre

(30) Priority: 04.03.1992 US 846512
(43) Date of publication of application: 08.09.1993
(73) Proprietor: MACDERMID INCORPORATED, Waterbury, Connecticut 06702 (US)
(72) Inventor: Cordani, John L., Waterbury, Connecticut 06704 (US)
(74) Representative: Pendlebury, Anthony

(56) References cited:
- EP-A- 0 315 891
- EP-A- 0 413 261
- FR-A- 2 233 418
- FR-A- 2 640 647
- JP-A-58 058 280
- US-A- 4 302 246
- US-A- 4 339 282
- US-A- 4 425 185
- US-A- 4 713 144
- PATENT ABSTRACTS OF JAPAN vol. 7, no. 147 (C-173)(1292) 28 June 1983

## Description

The present invention relates to a process for the stripping of tin or tin-lead alloys (i.e., solder) from a copper metal surface, and more particularly to a process for treating tin-coated or solder-coated copper surfaces in the course of manufacture of printed circuit boards to strip the tin or solder therefrom and expose the underlying copper metal.

In the course of manufacturing printed circuit boards, it is commonplace to deposit a layer of tin or tin-lead alloy (solder) on all or selected conductive copper surfaces of the board defining traces, throughholes, surrounding pad areas and the like, to serve, for example, as an etch resist in the subsequent etching away of other copper surfaces of the board. In many cases, it is thereafter necessary to strip the tin or tin-lead alloy from all or selected copper surfaces coated therewith. For example, it often is necessary to strip tin or tin-lead from copper surfaces at selected board areas (e.g., contact fingers) so that the surfaces can be plated with nickel and/or gold, or it may be necessary to strip tin or tin-lead from copper surfaces so that a solder mask can be applied over a bare copper surface (so-called SMOBC processes). Oftentimes, it simply is necessary to strip tin or tin-lead from a reject piece as part of the process for recovering and reusing underlying copper material. Also, while particularly apropos of printed circuit board manufacture, the need to strip away tin or tin-lead layers from copper surfaces also arises in other contexts where tin or tin-lead has been applied over a copper surface for decorative and/or functional purposes.

In addition, when copper metal surfaces are coated with tin or tin-lead alloys, a thin layer or film of copper-tin alloy (or intermetallic) typically forms at the layer interface, which film progressively increases in thickness with time. Accordingly, in processes designed to strip away the tin or tin-lead layer to expose copper metal, it is necessary to insure that this copper-tin intermetallic also is removed.

Compositions designed to strip tin and/or tin-lead coatings from copper surfaces are known in the art. One class of such compositions includes those based upon hydrogen peroxide and hydrofluoric acid or a fluoride. See, e.g., U.S. Patent Nos 3,926,699; 3,990,982; 4,297,257; 4,306,933; 4,374,744 and 4,673,521.

Another class involves those employing nitro-substituted aromatic compounds as a principal ingredient, often in conjunction with an inorganic acid (see, e.g., U.S. Patent Nos. 3,677,949; 4,004,956; 4,397,753; and 5,035,749) or an organic acid (see U.S. Patent No. 4,439,338 disclosing the use of alkylsulfonic acids).

In EP 0413261 (≡ U.S. Patent 5035749 mentioned above) there is disclosed a two step procedure for stripping tin or tin-lead alloy from a copper substrate. In the first step, the layer of tin or tin-lead is dissolved by using a first removing agent usually comprising an aromatic compound having at least one nitro substituent carried on the aromatic ring thereof (e.g. o-, m- or p- nitrobenzene sulphonic acid), at least one specified organic or inorganic acid and at least one inorganic or organic compound which liberates a halogen atom or a halogen-containing complex ion in an acidic solution. In the second step of the process, the remaining intermetallic layer of tin and copper is removed with a second removing agent, typically an oxidising agent selected from ferric chloride, cupric chloride and persulphates, thereby causing the underlying copper substrate to the exposed.

Stripping solutions incorporating a nitrogen-containing heterocyclic aromatic compound are disclosed in JP-A-58058280 (Chem. Abs., Vol 99, 10, 1983, Abstract No. 75413q), which discloses a stripping composition comprising nitric acid, ferric chloride, a hydroxycarboxylic acid such as glycolic acid and a nitrogen-containing heterocyclic aromatic compound which is sulphur-free, such as imidazole.

Other known stripper compositions and processes are described in U.S. Patents Nos. 4,424,097 and 4,687,545.

Nitric acid-based strippers also have long been used in the art. See, e.g., the discussion in U.S. Patent No. 4,713,144, and the use therein of a composition of nitric acid, sulfamic acid and ferric nitrate; see also U.S. Patents Nos. 4,919,752 and 4,964,920 relating to nitric acid-based strippers.

The said U.S. Patent 4919752 (≡ EP-A-0315891) describes a stripping solution containing nitric acid and a corrosion inhibitor selected from block copolymers of propylene oxide and ethylene oxide, fluorocarbon surfactants, polyethylene glycols with a molecular weight more than 2000 and polyols. It is stated that the intermetallic layer can be completely removed if the stripping solution in addition includes ferric chloride.

Difficulties arise with all these known stripper compositions. The peroxide-fluoride system is very exothermic and, unless the solution is cooled continuously, temperatures are quickly reached where the peroxide decomposes. Also, the system is highly aggressive, running risk of attack on the copper and, as a result of the fluoride, attack of the glass typically present in the glass-reinforced substrates (e.g., epoxy-glass) used in printed circuit manufacture. Still a further problem with the use of peroxide-fluoride systems in the stripping of tin-lead alloys is the formation of a large volume of lead fluoride sludge which eventually interferes with stripping, requires frequent cleaning of tanks and equipment, and poses significant waste disposal problems.

Strippers based upon nitro-substituted aromatic compounds are prone to redeposition of tin onto the copper from the stripping bath, which can be difficult to remove without excessive attack on the copper, and also are plagued by sludge formation. Nitric acid-based strippers generally form large volumes of sludge which, apart from the above-noted problems, can become adhered to the surfaces of the copper or to the printed circuit board substrate. Still further, most such systems require two-step processing in order to insure removal of copper-tin intermetallic residing on the copper surface after first removal of tin or tin-lead.

The formation of sludges and the highly corrosive nature of many of these stripper solutions also generally limits their practical use to processes where the surfaces to be treated are dipped or immersed in the solution, i.e., they are incompatible with the equipment which would be used to apply the solutions by a spraying technique.

In U.S. Patent No. 4,957,653, the disclosure of which is incorporated herein by reference, there are described improved compositions for the stripping of tin or tin-lead alloy, as well as any underlying copper-tin alloy, from a copper surface, the compositions being comprised of an aqueous solution of an alkane sulfonic acid and ferric nitrate. Also incorporated herein by reference are the disclosures of related U.S. Patent Nos. 4,944,851 and 4,921,571, directed, respectively, to electrolytic means for regenerating such alkane sulfonic acid/ferric nitrate compositions and to the inclusion in such compositions of inhibitors which minimize attack on the underlying copper surface. Among the outstanding advantages associated with these alkane sulfonic acid/ ferric nitrate compositions is their ability to rapidly remove tin or tin-lead, and any underlying copper-tin alloy, from copper surfaces in a single application process (e.g., either immersion or spraying) without concomitant formation of any appreciable sludge or precipitate.

Despite the outstanding effectiveness of these alkane sulfonic acid-based stripping compositions, they are subject to the commercial problem of being relatively expensive, largely attributable to the high cost of the alkane sulfonic acids, such as methane sulfonic acid (MSA). U.S. Patent No. 5,017,267, also incorporated herein by reference, addresses this problem and provides at least a partial solution thereto by utilizing a source of chlorate ion as a means for reducing the quantity of alkane sulfonic acid normally required. For example, a methane sulfonic acid/ferric nitrate/nitric acid composition normally requiring 540 g/l of 70% MSA can be reformulated with inclusion of 40 g/l sodium chlorate and reduction of MSA to 270 g/l without loss of stripping effectiveness. Given the high costs of MSA and other alkane sulfonic acids, however, these compositions with reduced MSA concentration still are relatively expensive, and it would be highly desirable to provide yet a lower cost formulation which nevertheless still provides the advantages and attributes of these more expensive systems.

According to the present invention, there is provided a process for stripping tin or tin-lead, and any underlying copper-tin intermetallic, from a copper surface, without bringing about any significant formation of sludge or precipitate, which process comprises contacting said surface with a stripping composition consisting essentially of nitric acid, ferric nitrate and a solution-soluble source of halide ion which have been dissolved to form an aqueous solution to make up the stripping composition, the aqueous solution consisting of from 30 to 600 g/l of nitric acid; from 40 to 60 g/l of ferric nitrate; and an amount of said source of halide ion sufficient to provide the solution with from 8 to 20 g/l halide ion; the said aqueous solution optionally including from 0.01 to 50 g/l of an inhibitor effective to minimize attack of the copper surface while not substantially slowing the speed of stripping of tin or tin-lead, and any underlying copper-tin intermetallic, as compared to that obtained without said inhibitor.

Quite surprisingly, it has been found that the process of the invention enables one to rapidly and efficiently strip tin or tin-lead, and any copper-tin intermetallic, from copper surfaces, without any significant formation of sludge or precipitate, and in a manner which provides for easy waste treatment, yet using relatively low-cost components and most particularly without need for an alkane sulfonic acid.

The process of the invention enables the required stripping function to be performed rapidly and in a single application. Furthermore, the compositions used in the present process have the advantage of being relatively inexpensive to make.

Compositions of this type are particularly useful in the environment of printed circuit board manufacture where copper circuitry on an insulating substrate has been provided with a tin or tin-lead layer (e.g., by immersion plating, electroplating, etc.) incident to the manufacturing process, but then is required to be removed from all or some of the copper surfaces as a further step in manufacture and/or simply in an effort to reclaim copper from a reject board. Generally, the tin or tin-lead layer over the copper will be on the order of 5.08 to 10.16 µm [.0002 to .0004 inches (.2 to .4 mils)] thick in typical circuit board manufacturing processes. Moreover, a thin layer or film of copper-tin intermetallic will form between the copper and the tin or tin-lead layers, generally having a thickness of about 50.8 to about 101.6 nm [about .002 to about .004 mils], which thickness increases with time. The invention is generally applicable, however, to the removal of tin or tin-lead, and any underlying copper-tin intermetallic, from any copper surface on which the tin or tin-lead has previously been applied, whether or not in the context of printed circuit board manufacture and whether or not the copper in turn is associated with some underlying insulating or conductive substrate.

The invention is applicable to the treatment of copper surfaces on which essentially pure tin metal has been deposited or, as is more common, copper surfaces on which tin-lead alloy has been deposited. Tin-lead alloys are interchangeably referred to herein as solder, and may range in tin content from about 1 to 99% by weight, with the balance lead, although most solders commercially employed have a weight ratio of tin:lead of about 60:40. Many such alloys also contain relatively minor amounts of additional metallic species which do not in any event affect the efficacy of the stripping compositions of the invention.

The nitric acid is present in the aqueous solution in a concentration in the range of from about 30 g/l to about 600 g/l, more preferably a concentration in the range of from about 100 g/l to 400 g/l, and most preferably a concentration in the range of from about 200 g/l to about 300 g/l. These concentrations are given in terms of nitric acid per se, but typically the composition of the invention will be made up using a 69-70 weight percent solution of nitric acid, which is a readily available commercial form thereof.

The ferric nitrate is present in the aqueous solution in a concentration in the range of from 40 g/l to 60 g/l. As with the nitric acid, these concentrations are given on the basis of ferric nitrate per se, but it typically will be the case that the ferric nitrate for use in make-up of the solution will be in the form of a 45 weight percent solution thereof, which is a readily available commercial form of ferric nitrate.

The source of halide ion can be any solution-soluble source thereof, and preferably a solution-soluble source of chloride ion, such as hydrochloric acid, ammonium chloride, sodium or potassium chloride or the like, with hydrochloric acid being preferred. The source of halide ion will be utilized in an amount which provides in the aqueous solution from 8 g/l to 20 g/l halide ion.

In the most preferred compositions for use in the process of the invention, the aqueous solution also will contain an inhibitor which is effective to minimize the possibility of attack of the underlying copper surface during the stripping process, but without substantially affecting the essential characteristics and properties of the stripping solution, i.e., stripping speed, stripping efficiency, no significant formation of sludge or precipitate, ease of waste treatment and the like. Among the suitable such inhibitors are those disclosed in U.S. Patent No. 4,921,571, incorporated herein by reference. Most preferred inhibitors are quaternary ammonium compounds, block copolymers of ethylene and propylene oxide, and ethoxylated alkylphenols (e.g., octyl or nonyl phenols), and mixtures thereof. The inhibitor typically will be used at relatively low concentrations, on the order of from about 0.01 g/l to about 5 g/l, but some inhibitors can be employed at higher concentrations, up to about 50 g/l, without adverse effect on stripping speed.

In the process of the invention in order to treat tin or solder-coated copper surfaces to remove the tin or solder therefrom, along with any copper-tin intermetallic, so as to expose the copper metal, the surfaces in questions are either immersed in the aqueous composition or the composition is sprayed on the surfaces. For typical tin or tin-lead and copper-tin layer thicknesses as earlier described, complete removal generally can be effected after from one to three minutes immersion, or upon spraying for anywhere from about 10 to 30 seconds. For spraying, the aqueous composition is typically continuously recirculated, and of course, for spraying or immersion processes, the aqueous composition can be used to treat a multitude of tin or tin-lead coated copper surfaces simultaneously or sequentially until such time as the stripping efficiency of the solution becomes uneconomically low.

The compositions used in the process of the invention can be employed at temperatures of from room temperature to about 65.6°C (about 150°F).

The invention is further described and illustrated with reference to the following Examples.

### EXAMPLE I

An aqueous solution was prepared containing 400 g/l of nitric acid (anhydrous), 40 g/l of ferric nitrate (anhydrous), 10 g/l of hydrochloric acid (anhydrous) and 1 g/l of a surfactant mixture containing a quaternary ammonium compound to serve as an inhibitor. The solution, at room temperature, was used to strip tin-lead (7.62 µm - 0.3 mils)-coated copper panels in an immersion process. The time needed for producing a clean copper surface tree of tin-lead and copper-tin intermetallic was on the order of about 1-3 minutes. The solution was employed in stripping a multitude of panels to a point where the solution contained 150 g/l (20 oz./gallon) of metals, at which stage no sludge or precipitate were evident in the solution. Attack of the copper surface of the panels was negligible.

### EXAMPLE II

An aqueous solution was prepared containing 300 g/l of nitric acid (anhydrous), 60 g/l ferric nitrate (anhydrous), 20 g/l of sodium chloride, and 1 g/l of the same surfactant mixture as used in Example I. The solution was used at room temperature to strip tin-lead (7.62 µm - 0.3 mils) coated copper panels in an immersion process. The time needed for producing a clean copper surface, free of tin-lead and copper-tin intermetallic, was on the order of about 1 to 3 minutes. The solution was employed in stripping a multitude of panels to a point where the solution contained about 127 g/l (about 17 oz./gallon) of metals, at which stage no sludge or precipitate was evident in the solution. Attack of the copper surface of the panels was negligible.

### EXAMPLE III

An aqueous solution was prepared containing 250 g/l of nitric acid (anhydrous), 40 g/l of ferric nitrate (anhydrous), 10 g/l of hydrochloric acid (anhydrous), and 1 g/l of the same surfactant mixture as used in Example I. The solution was used at room temperature to strip tin-lead (7.62µm - 0.3 mils) coated copper panels in a spray process. The time needed for producing a clean copper surface, free of tin-lead and copper-tin intermetallic, was on the order of about 30 seconds. The solution was employed in stripping a multitude of panels to a point where the solution contained 161 g/l (21.5 oz./gallon) of metals, at which stage no sludge or precipitate was evident in the solution. Attack of the copper surface of the panels was negligible.

## Claims

1. A process for stripping tin or tin-lead, and any underlying copper-tin intermetallic, from a copper surface, without bringing about any significant formation of sludge or precipitate, which process comprises contacting said surface with a stripping composition consisting essentially of nitric acid, ferric nitrate and a solution-soluble source of halide ion which have been dissolved to form an aqueous solution to make up the stripping composition, the aqueous solution consisting of from 30 to 600 g/l of nitric acid; from 40 to 60 g/l of ferric nitrate; and an amount of said source of halide ion sufficient to provide the solution with from 8 to 20 g/l halide ion; the said aqueous solution optionally including from 0.01 to 50 g/l of an inhibitor effective to minimize attack of the copper surface while not substantially slowing the speed of stripping of tin or tin-lead, and any underlying copper-tin intermetallic, as compared to that obtained without said inhibitor.

2. A process according to Claim 1, wherein the solution-soluble source of halide ion is a solution-soluble source of chloride ion.

3. A process according to Claim 2, wherein the solution-soluble source of halide ion is hydrochloric acid.

4. A process according to any one of Claims 1 to 3 wherein the contacting is performed by immersing the copper surface in the said aqueous solution and/or by spraying the aqueous solution on the copper surface.

## Patentansprüche

1. Verfahren zum Entfernen von Zinn oder Zinn-Blei und irgendwelcher darunterliegenden Kupfer-Zinn-Intermetallverbindungen von einer Kupferoberfläche ohne merkliche Bildung von Schlamm oder Niederschlag, wobei das Verfahren umfaßt: Kontaktieren der Oberfläche mit einer Entfernungszusammensetzung, welche im wesentlichen aus Salpetersäure, Eisen(III)-Nitrat und einer in der Lösung löslichen Quelle von Halogenidionen besteht, die zur Bildung einer wäßrigen Lösung für die Herstellung der Entfernungszusammensetzung gelöst sind, wobei die wäßrige Lösung 30 bis 600 g/l Salpetersäure; 40 - 60 g/l Eisen(III)-Nitrat; und eine Menge der Quelle für Halogenidionen enthält, die zur Bildung der Lösung mit 8 bis 20 g/l Halogenidionen ausreicht, und die wäßrige Lösung wahlweise 0,01 bis 50 g/l eines Inhibitors enthält, der einen Angriff auf die Kupferoberfläche minimal macht, während er im wesentlichen keine Verlangsamung der Geschwindigkeit der Entfernung von Zinn oder Zinn-Blei und irgendeiner darunterliegenden Kupfer-Zinn-Intermetallverbindung im Vergleich zu der ohne diesen Inhibitor erzielten bewirkt.

2. Verfahren nach Anspruch 1, bei welchem die in der Lösung lösliche Quelle von Halogenidionen eine in der Lösung lösliche Quelle von Chloridionen ist.

3. Verfahren nach Anspruch 2, bei welchem die in der Lösung lösliche Quelle von Halogenidionen Salzsäure ist.

4. Verfahren nach einem der Ansprüche 1 bis 3, bei welchem das Kontaktieren durch Eintauchen der Kupferoberfläche in die wäßrige Lösung und/oder Aufsprühen der wäßrigen Lösung auf die Kupferoberfläche durchgeführt wird.

## Revendications

1. Procédé pour enlever l'étain ou l'étain-plomb, et toute couche intermétallique de cuivre-étain sous-jacente, d'une surface de cuivre, sans provoquer de formation significative quelconque de boue ou de précipité, lequel procédé comporte la mise en contact de ladite surface avec une composition d'enlèvement essentiellement constituée par de l'acide nitrique, du nitrate ferrique et une source d'ion halogénure soluble en solution qui ont été dissous pour former une solution aqueuse pour préparer la composition d'enlèvement, la solution aqueuse se composant de 30 à 600 g/l d'acide nitrique ; de 40 à 60 g/l de nitrate ferrique ; et d'une quantité de ladite source d'ion halogénure suffisante pour fournir à la solution de 8 à 20 g/l d'ion halogénure ; ladite solution aqueuse comprenant éventuellement de 0,01 à 50 g/l d'un inhibiteur efficace pour minimiser l'attaque de la surface de cuivre tout en ne diminuant pas sensiblement la vitesse d'enlèvement de l'étain ou de l'étain-plomb, et de toute couche intermétallique de cuivre-étain sous-jacente, en comparaison avec celle obtenue sans ledit inhibiteur.

2. Procédé selon la revendication 1, dans lequel la source d'ion halogénure soluble en solution est une source d'ion chlorure soluble en solution.

3. Procédé selon la revendication 2, dans lequel la source d'ion halogénure soluble en solution est l'acide chlorhydrique.

4. Procédé selon l'une quelconque des revendications 1 à 3, dans lequel la mise en contact est réalisée par immersion de la surface de cuivre dans ladite solution aqueuse et/ou par pulvérisation de la solution aqueuse sur la surface de cuivre.
